(19) **Europäisches Patentamt European Patent Office Office européen des brevets**

(11) **EP 1 606 821 B1**

(12) **EUROPEAN PATENT SPECIFICATION**

(45) Date of publication and mention of the grant of the patent:
**08.10.2008 Bulletin 2008/41**

(51) Int Cl.:
**G11C 11/34** (2006.01)     **G11C 16/28** (2006.01)

(21) Application number: **04711923.5**

(22) Date of filing: **17.02.2004**

(86) International application number:
**PCT/US2004/004729**

(87) International publication number:
**WO 2004/077439 (10.09.2004 Gazette 2004/37)**

(54) **AN APPARATUS AND METHOD FOR A CONFIGURABLE MIRROR FAST SENSE AMPLIFIER**

VORRICHTUNG UND VERFAHREN FÜR EINEN KONFIGURIERBAREN SPIEGELSCHNELLLESEVERSTÄRKER

APPAREIL ET PROCEDE RELATIFS A UN AMPLIFICATEUR DE DETECTION RAPIDE CONFIGURABLE A MIROIR

(84) Designated Contracting States:
**DE FR GB NL**

(30) Priority: **25.02.2003  IT TO20030132**
**18.07.2003  US 622804**

(43) Date of publication of application:
**21.12.2005  Bulletin 2005/51**

(73) Proprietor: **ATMEL CORPORATION**
**San Jose, California 95131 (US)**

(72) Inventors:
 • **BEDARIDA, Lorenzo**
  **I-20059 Vimercate (IT)**
 • **SACCO, Andrea**
  **I-15100 Alessandria (IT)**
 • **MARZIANI, Monica**
  **I-20148 Milano (IT)**

(74) Representative: **Manitz, Finsterwald & Partner GbR**
**Martin-Greif-Strasse 1**
**80336 München (DE)**

(56) References cited:
| | |
|---|---|
| US-A- 5 163 021 | US-A- 5 198 997 |
| US-A- 5 444 656 | US-A- 5 748 534 |
| US-A- 5 917 754 | US-A- 6 108 259 |
| US-A1- 2003 128 567 | US-B1- 6 333 885 |
| US-B1- 6 366 497 | US-B1- 6 414 876 |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

1. Field of the Invention

The invention relates to memory and to configuring a mirror sense amplifier in order to create a reference current by which to read the state of flash memory cells. More particularly, the invention relates to an amplifier system and to a method of configuring a mirror sense amplifier system for flash memory. An amplifier system and a method of this kind are disclosed in US 5 163 021.

2. The State of the Art

A system for reading flash memory typically employs a differential sense amplifier to compare the amount of current flowing through a reference cell to a selected memory cell. A sensing circuit determines if the selected memory cell has logic 1 or logic 0 stored therein based on the comparison.

When the amount of current flowing through the reference cell is larger than the amount of current flowing through the selected memory cell then logic value 0 (programmed) is read from the memory cell. When the amount of current flowing through the reference cell is smaller than the amount of current flowing through the selected memory cell then logic value 1 (erased) is read from the memory cell.

A current reference, generally half the current of an erased cell (logic value 1), enables the system to determine, through comparison with the current of the memory cell, what logic value is stored in the selected memory cell. The current reference is typically set so that the system distinguishes between programmed and erased states.

A reference cell generates the reference current. The reference cell is located in an array outside the memory array in order to avoid the write and erase cycles that modify the threshold of the reference cells. The reference current is carried around the chip by a system of current mirrors.

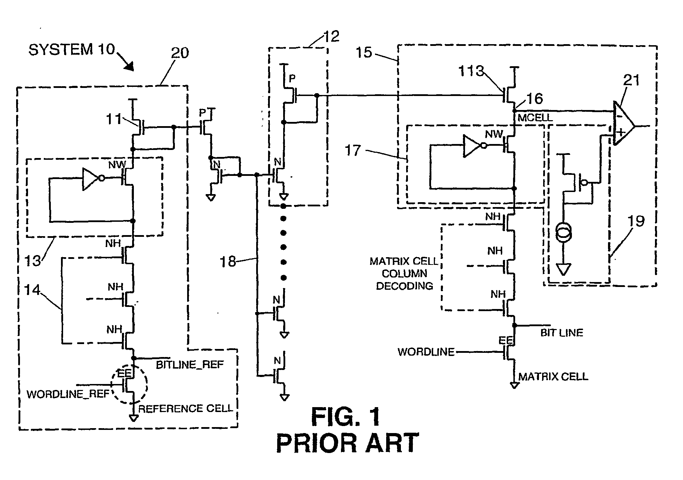

Figure 1 illustrates system 10 wherein local mirror 12 mirrors a reference current inside sense amplifier 15.

Sense amplifier 15 has bias circuit 17 to bias a bit line. Reference voltage generator 19 provides a voltage level, usually generated from the reference cell current, for comparator 21. Comparator 21 determines if the reading array cell is erased or programmed.

Memory access time depends on how rapidly the reference current circuit can turn on. Node 16 is precharged at a reference value and allowed to evolve. Equalization circuitry (not shown) permits the evolution of charge at node 16. The equalization circuitry produces a load effect on a signal on line 18.

One drawback to the aforementioned design is that since the signal on line 18 is the same for all sense amplifiers 15, the load effect may reduce the performance for fast memory access. Additionally, the added load effect of the equalization circuitry increases memory access time. Furthermore, frequent reading of the memory cells may change the threshold voltages of the reference cells and therefore compromise their reliability.

The minimum Vcc for circuit 20 used to bias the reference cell depends on p-channel transistor 11 in diode configuration and on cascode 13 that biases the reference bit line at about 1V, so that if transistor 11 is conductive enough then its $V_{GS}$ can be approximated to its threshold VthP1 and minimum Vcc is

$$V_{CC} = V_{THP1} + 1V + V_{DSATN1}.$$

In modem, low voltage circuits the minimum $V_{CC}$ should be as low as possible.

The amplifier system as disclosed in US 5 163 021 comprises flash reference cells for providing a current for comparison. Programming voltages or erasing voltages are selectively supplied each reference cell which then serves as a reference for the reading of an addressed memory cell. The reference cells are described as being an identical device as that of the memory cells. Since the memory cells are part of a flash EEprom system, it is clear that the flash reference cells are used to read the reference voltage signals. Clocked switches are provided that time-multiplex the connection between the reference cells and the sense amplifier.

US 5 748 534 discloses a read circuit comprising an amplifier, means for connecting a node of a selected memory to an input terminal of the amplifier, means for applying a current to the input terminal of the amplifier, and means for connecting an output terminal of the amplifier to a gate of the selected memory cell, wherein an output voltage of the amplifier, that is provided while the output terminal is connected to the gate and the input terminal is connected to the node, indicates a data value stored in the selected memory cell.

US 5 917 754 discloses a memory devise including a memory cell whose data state is sensed by a sense amplifier. With this known memory device a current drawn by a floating gate device can be modified by programmably adjusting its gate voltage.

BRIEF DESCRIPTION OF THE INVENTION

The invention provides a configurable mirror sense amplifier system for flash memory and a method of configuring a mirror sense amplifier system for flash memory as defined in the claims. A configurable array of selectable transistors whereby one or more transistors serves as a current reference for memory cells in a flash memory device. The current reference is compared to the current in a memory cell and a logic level of 0 or 1 is read from the memory cell based on whether the current in the memory cell is greater than or less than the current reference.

The array is configured in order to provide a suitable current reference level that allows the system to distinguish between current in the memory cell intended to represent logic level 0 and current intended to represent logic level 1. ,

The array is configured by either selecting one or more transistors to serve as the current reference, or a combination of selecting and varying the voltage applied to the gate at least one of at least one transistor in order to vary the amount of current flowing through the transistor.

BRIEF DESCRIPTION OF THE FIGURES

FIG. 1 is a schematic diagram illustrating a prior art memory cell content reader.
FIG. 2 is a schematic diagram illustrating one embodiment of the invention.
FIG. 3 is a schematic diagram illustrating one embodiment of the invention.
FIG. 4 is a flow diagram illustrating a method of configuring a mirror sense amplifier.
FIG. 5 is a flow diagram illustrating a method of configuring a mirror sense amplifier.
FIG. 6 is a flow diagram illustrating a method of configuring a mirror sense amplifier.

DETAILED DESCRIPTION OF THE INVENTION

Persons of ordinary skill in the art will realize that the following description of the invention is only illustrative and not in any way limiting. Other embodiments of this invention will be readily apparent to those skilled in the art having benefit of this disclosure.

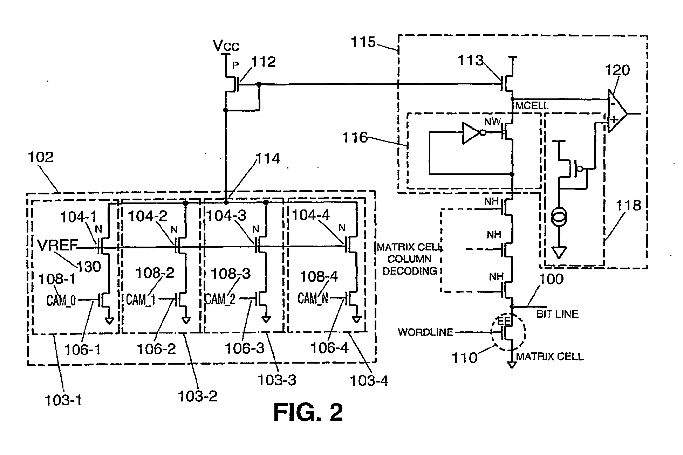

FIG. 2 illustrates one embodiment of the invention. Bitline current 100 is compared to one or more currents from reference circuit 102. Configurable transistors 104 (or reference transistors) are biased with the same reference voltage. The reference voltage is internally generated, stable and independent from power supply and temperature variations. In one embodiment, the reference voltage is a bandgap reference (not shown).

Current passing through transistor 112 is used as a reference current. The amount of current passing through transistor 112 is a function of how many of transistors 104 are biased to an active (conducting) mode. Transistors 104 are in a configurable array and one or more of transistors 104 are biased to an active mode in order to provide a desired current through transistor 112 and therefore a desired reference current. In one embodiment, each transistor 104 in the array is part of a group. Current through transistors 104 is selected by biasing transistors 106. For example, transistor group 103-1 is comprised of transistors 104-1 and 106-1. In order to select current passing through transistor 104-1, which is also the same current passing through transistor 106-1 and group 103-1, transistor 106-1 is biased to an active mode. Transistor group 103-2 is comprised of transistors 104-2 and 106-2. In order to select current passing through transistor group 103-2, transistor 106-2 is biased to an active mode. Transistor group 103-3 is comprised of transistors 104-3 and 106-3. In order to select current passing through transistor group 103-3, transistor 106-3 is biased to an active mode, and so on. The selected transistor group is rapidly switched on. Load effects due to transistor groups 103 allow faster access time.

The sum of the current through transistor groups 103 is the same as current through transistor 112. Current through transistor 112 is mirrored by mirror transistor 113 and compared with current in a selected memory cell, for example memory cell 110. After selecting one or more transistor groups 103, current through those groups, mirrored by transistor 113, is compared to memory cells. If current in memory cell 110 is greater than current in selected transistor group 103 then a logic level of 1 is assigned to memory cell 110. Conversely, if current in memory cell 110 is less than current in selected transistor group 103 then a logic level of 0 is assigned to memory cell 110. If more than one transistor group 103 is selected then the sum of the current through the selected groups is compared to the current in the memory cell. In one embodiment, transistors 104 are N-channel transistors operated in saturation.

The minimum for Vcc

$$V_{CC} = V_{TH} + V_{NODE1}$$

where $V_{TH}$ is approximately the threshold voltage of transistor 112 and $V_{NODE1}$ is the voltage across node 114 and ground. A lower minimum Vcc allows for a broader range of low voltage applications for the invention in comparison to circuits having a higher minimum Vcc.

Sense amplifier 115 includes circuit 116 for biasing bit line 100 and transistor 113 that forces a reference current on bit line 100. Reference voltage generator 118 provides a voltage level typically generated from the reference cell current. Comparator 120 to determines if the memory cell is erased or programmed.

With respect to Figure 2, a reference current is typically established through experimentation. The reference current should be sufficiently above the current in the memory cell that represents a logic level of 0 and sufficiently below the current that represents a logic level of 1 so that incorrect values are not read from flash memory.

Transistor 113 mirrors the current passing through transistor 112. Once a suitable reference current is established, the current passing through transistor 112 and will be compared, through the mirror of transistor 113, to current within memory cells.

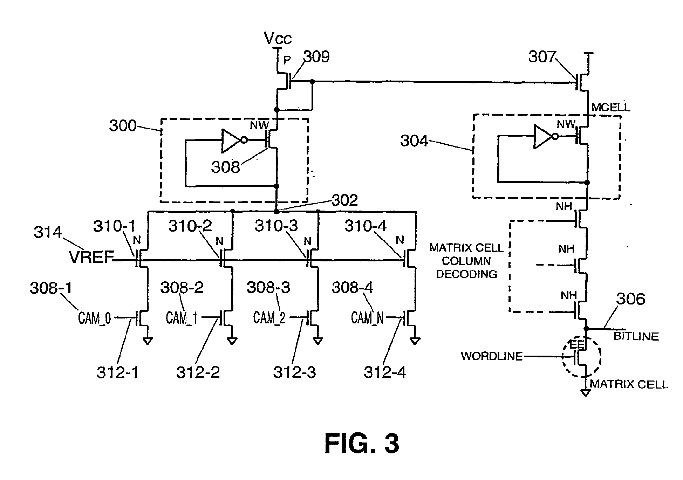

One method of establishing the reference current is with signals 108. Signals 108 activate each group based on current values passing through the respective transistors. For example, if current passing through transistors 104-1 and 104-2 provides a suitable reference current, then signals 108-1 and 108-2 will activate transistors 106-1 and 106-2. If current passing through transistor 104-4 provides a suitable reference current then signal 108-4 will activate transistor 106-4. One skilled in the art will recognize that each group of transistors by itself may provide a suitable reference current, and that other combinations of groups may provide suitable reference current as well. One skilled in the art will also recognize that fewer and more groups may be used and that this example applies to the embodiment illustrated in Figure 3 as well.

In one embodiment, this configuration occurs during device testing and is not repeated. In another embodiment, this configuration occurs during power-up for the circuit.

Another method of adjusting the reference current is by adjusting the voltage on signal 130, which couples to the gate of each of transistors 104. Changing the voltage on signal 130 will change the amount of current flowing through transistors 104. One skilled in the art will recognize that this method applies to the embodiment in Figure 3 and that a combination of this method and the previous method may be used.

Figure 3 illustrates one embodiment used to avoid Early effect. The Early effect depends on the shortening of the effective channel length in the saturation region caused by VDS being greater than the VDSAT limit. In this condition, the depletion region around the drain junction becomes wider, causing the standard drift transport equations to be replaced by more complex equations. The effect becomes more pronounced as channel length shortens.

Cascode structure 300 biases node 302. In one embodiment, bit line regulator 304 biases matrix bit line 306 at 1V while cascode structure 300 biases voltage at node 302 in order to avoid Early effect and may be lower than the voltage at node 306.

The voltage minimum for $V_{CC}$ in the circuit of Figure 3 is

$$V_{CC} = V_{TH} + V_{NODE2} + V_{DS}$$

where $V_{TH}$ is the threshold voltage of transistor 309 and $V_{NODE2}$ is the voltage across node 302 and $V_{DS}$ is the drain-to-source voltage across transistor 308. In one embodiment $V_{NODE2}$ is less than 1V. As previously stated, a minimum $V_{CC}$ lower for the invention compared to the prior art allows for a greater range of low voltage applications.

While a sense amplifier is not shown on Figure 3, those skilled in the art recognize that the circuit in Figure 3 can include a sense amplifier as shown in Figure 2.

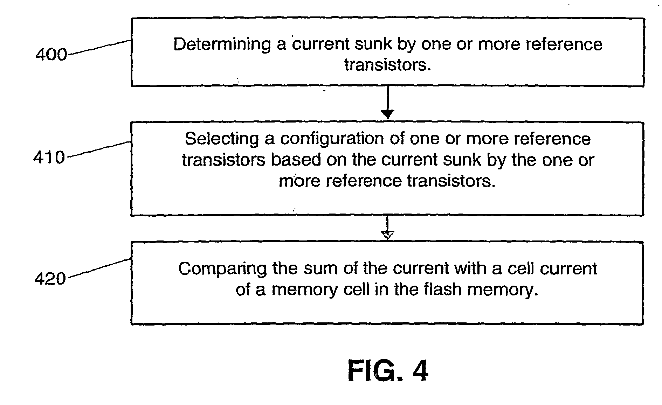

Figure 4 is a flow diagram illustrating a method of configuring a mirror sense amplifier. In block 400, determining a current sunk by one or more reference transistors. In block 410, selecting a configuration at least one of at least one reference transistor based on the current sunk by the one or more reference transistors. In block 420, comparing the sum of the current with a cell current in a memory cell in the flash memory.

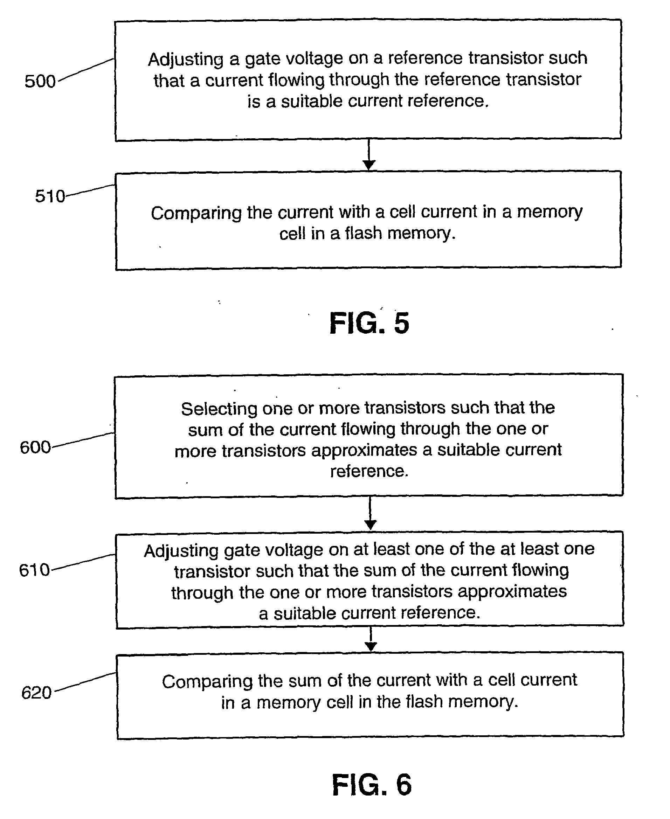

Figure 5 is a flow diagram illustrating a method of configuring a mirror sense amplifier. In block 500, adjusting the gate voltage in a reference transistor such that a current flowing through the reference transistor is a suitable current reference. In block 510, comparing the current with a cell current in a memory cell in the flash memory.

Figure 6 is a flow diagram illustrating a method of configuring a mirror sense amplifier. In block 600, selecting one or more transistors such that the sum of the current flowing through the one or more transistors approximates a suitable current reference. In block 610, adjusting the gate voltage on at least one of at least one transistor such that the sum of the current flowing through the one or more transistors approximates a suitable current reference. In block 620, comparing the sum of the current with a cell current in a memory cell in the flash memory.

While embodiments and applications of this invention have been shown and described, it would be apparent to those skilled in the art that many more modifications than mentioned above are possible without departing from the inventive concepts herein. The invention, therefore, is not to be restricted except by the appended claims.

**Claims**

1. A configurable mirror sense amplifier system for flash memory comprising:

a power source generating a reference voltage (130; 314); and
an array (102) wherein the array comprises a first plurality of transistors (104; 310) and a means for selecting, each of the first plurality of transistors (104; 310) coupled to the means for selecting, the array (102) biased at the reference voltage (130; 314) and configured to provide a reference current for comparison with a flash memory cell current;
wherein
said reference voltage (130; 314) is applied to the gates of said first plurality of transistors (104; 310), the means for selecting comprises a second plurality of transistors (106; 312), each one of the second plurality of transistors (106; 312) coupled to a corresponding one of the first plurality of transistors (104; 310), wherein each one of the second plurality of transistors (106; 312) is configured to receive a signal (108; 308) and bias the corresponding one of the first plurality of transistors (104; 310) to an active mode in order to provide the reference current for comparison to the flash memory cell current, with the amount of said reference current being a function of how many transistors of said first plurality of transistors (104; 310) are selectively biased to said active mode by said second plurality of transistors (106; 312) and with the system being adapted for the configuration occurring during device testing or during power-up for the circuit.

2. The system of claim 1 wherein the reference voltage is internal, stable and independent from variations of a power supply or temperature.

3. The system of claim 2 wherein each of the first plurality of transistors (104; 310) is in parallel.

4. The system of claim 3 further comprising a mirror transistor (113; 307) coupled to the array.

5. The system of claim 4 wherein a minimum voltage needed for the system is the threshold voltage of the mirror transistor (113; 307) plus the voltage across the array.

6. The system of claim 5 wherein the first plurality of transistors (104; 310) is rapidly switched on.

7. The system of claim 5 further comprising a plurality of sense amplifiers (115) associated with the flash memory and a plurality of arrays (102), one of each of the plurality of sense amplifiers (115) coupled to one of each of the plurality of arrays (102).

8. The system of claim 5 further comprising a plurality of sense amplifiers (115) associated with the flash memory coupled to the array (102).

9. The system of claim 8 where the first plurality of transistors (104; 310) are N-channel transistors.

10. The system of claim 1 wherein the reference voltage (130; 314) can be modified in order to modify the reference current for comparison to the flash memory cell current.

11. The system of claim 1 further comprising:

a cascode structure (300) coupled to the first plurality of transistors (310) and configured to bias the first plurality of transistors (310) in order to reduce Early effect.

12. The system of claim 11 further comprising a mirror transistor (309) coupled to the cascode structure (300).

13. The system of claim 12 wherein the reference voltage (130; 314) can be modified in order to modify the current for comparison to the flash memory cell current.

14. A method of configuring a mirror sense amplifier system for flash memory **characterised in that** the method comprises:

determining a current sunk by one or more reference transistors of a first plurality of transistors (104; 310);
selecting a configuration of at least one reference transistor of said first plurality of transistors (104; 310) based on the current sunk by the at least one reference transistor in order to provide a reference current for comparison to a flash memory cell current, wherein the configuration is selected by at least one biasing transistor of a second plurality of transistors (104; 310) which is coupled to the at least one reference transistor receiving a signal (108; 308) and biasing the at least one reference transistor to an active mode, with the amount of said reference current being a function of how many transistors of said first plurality of transistors (104; 310) are selectively biased to said active mode by said second plurality of transistors (106; 310) and with the configuration occurring during device testing or during power-up of the circuit; and
comparing the reference current with the flash memory cell current.

15. The method of claim 14 further comprising:

adjusting the gate voltage on at least one of the at least one transistor biased to the active mode in order to adjust the reference current to an amount which approximates a suitable current reference.

**Patentansprüche**

1. Konfigurierbares Spiegelleseverstärkersystem für einen Flashspeicher, das umfasst:

eine Energiequelle, die eine Referenzspannung (130; 314) erzeugt; und
eine Matrix (102), wobei die Matrix eine erste Vielzahl von Transistoren (104; 310) und ein Mittel zum Wählen umfasst, wobei jeder der ersten Vielzahl von Transistoren (104; 310) mit dem Mittel zum Wählen gekoppelt ist, wobei die Matrix (102) mit der Referenzspannung (130; 314) vorgespannt und ausgestaltet ist, um einen Referenzstrom zum Vergleich mit einem Flashspeicher-Zellenstrom zu liefern;

wobei die Referenzspannung (130; 314) an die Gates der ersten Vielzahl von Transistoren (104; 310) angelegt wird, wobei das Mittel zum Wählen eine zweite Vielzahl von Transistoren (106; 312) umfasst, wobei jeder der zweiten Vielzahl von Transistoren (106; 312) mit einem entsprechenden der ersten Vielzahl von Transistoren (104; 310) gekoppelt ist, wobei jeder der zweiten Vielzahl von Transistoren (106; 312) ausgestaltet ist, um ein Signal (108; 308) zu empfangen und den entsprechenden der ersten Vielzahl von Transistoren (104; 310) in einen aktiven Modus vorzuspannen, um den Referenzstrom zum Vergleich mit dem Flashspeicher-Zellenstrom bereitzustellen, wobei der Betrag des Referenzstroms eine Funktion davon ist, wie viele Transistoren der ersten Vielzahl von Transistoren (104; 310) durch die zweite Vielzahl von Transistoren (106; 312) selektiv in den aktiven Modus vorgespannt sind, und wobei das System dafür angepasst ist, dass das Konfigurieren während eines Testens der Einrichtung oder während eines Einschaltens der Schaltung erfolgt.

2. System nach Anspruch 1, wobei die Referenzspannung intern, stabil und unabhängig von Schwankungen einer Energieversorgung oder einer Temperatur ist.

3. System nach Anspruch 2, wobei jeder der ersten Vielzahl von Transistoren (104; 310) parallel geschaltet ist.

4. System nach Anspruch 3, das ferner einen mit der Matrix gekoppelten Spiegeltransistor (113; 307) umfasst.

5. System nach Anspruch 4, wobei eine minimale für das System benötigte Spannung die Schwellenwertspannung des Spiegeltransistors (113; 307) plus die Spannung an der Matrix ist.

6. System nach Anspruch 5, wobei die erste Vielzahl von Transistoren (104; 310) schnell eingeschaltet wird.

7. System nach Anspruch 5, das ferner eine Vielzahl von mit dem Flashspeicher verbundenen Leseverstärkern (115) und eine Vielzahl von Matrizen (102) umfasst, wobei jeder der Vielzahl von Leseverstärkem (115) mit je einer der Vielzahl von Matrizen (102) gekoppelt ist.

8. System nach Anspruch 5, das ferner eine Vielzahl von Leseverstärkem (115) umfasst, die mit dem Flashspeicher verbunden sind, der mit der Matrix (102) gekoppelt ist.

9. System nach Anspruch 8, wobei die erste Vielzahl von Transistoren (104; 310) N-Kanal-Transistoren sind.

10. System nach Anspruch 1, wobei die Referenzspannung (130; 314) modifiziert werden kann, um den Referenzstrom zum Vergleich mit dem Flashspeicher-Zellenstrom zu modifizieren.

11. System nach Anspruch 1, das ferner umfasst:

eine Kaskoden-Struktur (300), die mit der ersten Vielzahl von Transistoren (310) gekoppelt ist und ausgestaltet ist, um die erste Vielzahl von Transistoren (310) vorzuspannen, um den Early-Effekt zu verringern.

12. System nach Anspruch 11, das ferner einen mit der Kaskoden-Struktur (300) gekoppelten Spiegeltransistor (309) umfasst.

13. System nach Anspruch 12, wobei die Referenzspannung (130; 314) modifiziert werden kann, um den Strom zum Vergleich mit dem Flashspeicher-Zellenstrom zu modifizieren.

14. Verfahren zum Konfigurieren eines Spiegelleseverstärkersystems für einen Flashspeicher, **dadurch gekennzeichnet, dass** das Verfahren umfasst:

Ermitteln eines Stroms, der von einem oder mehreren Referenztransistoren einer ersten Vielzahl von Transistoren (104; 310) abgesenkt wurde;

Wählen einer Konfiguration mit mindestens einem Referenztransistor aus der ersten Vielzahl von Transistoren (104; 310) auf der Grundlage des Stroms, der von dem mindestens einen Referenztransistor abgesenkt wurde, um einen Referenzstrom zum Vergleich mit einem Flashspeicher-Zellenstrom zu liefern, wobei die Konfiguration durch mindestens einen Vorspannungstransistor einer zweiten Vielzahl von Transistoren (104; 310), welcher mit dem mindestens einen Referenztransistor gekoppelt ist, gewählt wird, welcher ein Signal (108; 308) empfängt und den mindestens einen Referenztransistor in einen aktiven Modus vorspannt, wobei der Betrag des Referenzstroms eine Funktion dessen ist, wie viele Transistoren der ersten Vielzahl von Transistoren (104; 310) durch die zweite Vielzahl von Transistoren (106; 310) selektiv in den aktiven Modus vorgespannt werden, und wobei das Konfigurieren während eines Testens der Einrichtung oder während eines Einschaltens der Schaltung erfolgt; und Vergleichen des Referenzstroms mit dem Flashspeicher-Zellenstrom.

**15.** Verfahren nach Anspruch 14, das ferner umfasst:

Einstellen der Gatespannung an mindestens einem des mindestens einen Transistors, der in den aktiven Modus vorgespannt ist, um den Referenzstrom auf einen Betrag einzustellen, welcher einer geeigneten Stromreferenz näherungsweise gleicht.

**Revendications**

**1.** Système amplificateur de détection configurable à miroir pour mémoire flash, comprenant :

une source de puissance qui génère un voltage de référence (130 ; 314) ; et
un réseau (102), ledit réseau comprenant une première pluralité de transistors (104 ; 310) et un moyen pour sélectionner, chacun de la première pluralité de transistors (104 ; 310) étant couplé au moyen pour sélectionner, le réseau (102) étant polarisé au voltage de référence (130; 314) et configuré pour fournir un courant de référence pour comparaison avec un courant de cellule de mémoire flash ;
dans lequel
ledit voltage de référence (130 ; 314) est appliqué aux grilles de ladite première pluralité de transistors (104 ; 310), les moyens pour sélectionner comprenant une seconde pluralité de transistors (106 ; 312), chacun de ladite seconde de pluralité de transistors (106 ; 312) étant couplé à un transistor correspondant de la première pluralité de transistors (104 ; 310), dans lequel chacun de la seconde pluralité de transistors (106 ; 312) est configuré pour recevoir un signal (108 ; 308) et polariser le transistor correspondant de la première pluralité de transistors (104 ; 310) vers un mode actif afin de fournir le courant de référence pour comparaison avec le courant de cellule de mémoire flash, l'intensité dudit courant de référence étant une fonction du nombre de transistors de ladite première pluralité de transistors (104 ; 310) qui sont sélectivement polarisés vers ledit mode actif par ladite seconde pluralité de transistors (106 ; 312), et le système étant adapté pour la configuration qui se produit pendant les tests du dispositif ou pendant la mise sous puissance pour le circuit.

**2.** Système selon la revendication 1, dans lequel le voltage de référence est interne, stable et indépendant vis-à-vis des variations d'une alimentation de puissance ou de la température.

**3.** Système selon la revendication 2, dans lequel chacun de la première pluralité de transistors (104 ; 310) est en parallèle.

**4.** Système selon la revendication 3, comprenant en outre un transistor à miroir (113 ; 307) couplé au réseau.

**5.** Système selon la revendication 4, dans lequel un voltage minimum nécessaire pour le système est le voltage seuil du transistor à miroir (113 ; 307), plus le voltage aux bornes du réseau.

**6.** Système selon la revendication 5, dans lequel la première pluralité de transistors (104 ; 310) est rapidement commutée.

**7.** Système selon la revendication 5, comprenant en outre une pluralité d'amplificateurs de détection (115) associés à la mémoire flash et une pluralité de réseaux (102), un de chacun de la pluralité d'amplificateurs de détection (115) étant couplé à l'un de chacun de la pluralité de réseaux (102).

**8.** Système selon la revendication 5, comprenant en outre une pluralité d'amplificateurs de détection (115) associés avec la mémoire flash couplée au réseau (102).

**9.** Système selon la revendication 8, dans lequel la première pluralité de transistors (104 ; 310) sont des transistors à N canaux.

**10.** Système selon la revendication 1, dans lequel le voltage de référence (130 ; 314) peut être modifié afin de modifier le courant de référence pour comparaison avec le courant de cellule de mémoire flash.

**11.** Système selon la revendication 1, comprenant en outre :

une structure cascode (300) couplée à la première pluralité de transistors (310) et configurée pour polariser la première pluralité de transistors (310) afin de réduire l'effet Early.

**12.** Système selon la revendication 11, comprenant en outre un transistor à miroir (309) couplé à la structure cascode (300).

**13.** Système selon la revendication 12, dans lequel le voltage de référence (130 ; 314) peut être modifié afin de modifier le courant pour comparaison avec le courant de cellule de mémoire flash.

**14.** Procédé pour configurer un système amplificateur de détection à miroir pour mémoire flash, **caractérisé en ce que** le procédé comprend :

la détermination d'un courant consommé par un ou plusieurs transistors de référence d'une première pluralité de transistors (104 ; 310) ;
la sélection d'une configuration d'au moins un transistor de référence de ladite première pluralité de transistors (104 ; 310) en se basant sur le courant consommé par ledit au moins un transistor de référence afin de fournir un courant de référence pour comparaison avec un courant de cellule de mémoire flash, dans lequel la configuration est choisie par au moins un transistor de polarisation d'une seconde pluralité de transistors (104 ; 310) qui est couplé audit au moins un transistor de référence recevant un signal (108 ; 308) et polarisant ledit au moins un transistor de référence vers un mode actif, l'intensité dudit courant de référence étant une fonction du nombre de transistors de ladite première pluralité de transistors (104 ; 310) qui sont sélectivement polarisés vers ledit mode actif par ladite seconde pluralité de transistors (106 ; 310), et avec la configuration qui se produit pendant les tests du dispositif ou pendant la mise sous puissance du circuit ; et
la comparaison du courant de référence avec le courant de cellule de mémoire flash.

**15.** Procédé selon la revendication 14, comprenant en outre :

l'ajustement du voltage de grille sur au moins un dudit au moins un transistor polarisé vers le mode actif afin d'ajuster le courant de référence à une intensité qui est une approximation d'une référence de courant appropriée.

FIG. 1
PRIOR ART

**FIG. 2**

**FIG. 3**

400 — Determining a current sunk by one or more reference transistors.

410 — Selecting a configuration of one or more reference transistors based on the current sunk by the one or more reference transistors.

420 — Comparing the sum of the current with a cell current of a memory cell in the flash memory.

# FIG. 4

> 500 — Adjusting a gate voltage on a reference transistor such that a current flowing through the reference transistor is a suitable current reference.

> 510 — Comparing the current with a cell current in a memory cell in a flash memory.

## FIG. 5

> 600 — Selecting one or more transistors such that the sum of the current flowing through the one or more transistors approximates a suitable current reference.

> 610 — Adjusting gate voltage on at least one of the at least one transistor such that the sum of the current flowing through the one or more transistors approximates a suitable current reference.

> 620 — Comparing the sum of the current with a cell current in a memory cell in the flash memory.

## FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5163021 A
- US 5748534 A
- US 5917754 A